(19) Europäisches Patentamt
European Patent Office
Office européen des brevets

(11) **EP 4 632 412 A1**

(12) **EUROPEAN PATENT APPLICATION**
published in accordance with Art. 153(4) EPC

(43) Date of publication:
**15.10.2025 Bulletin 2025/42**

(21) Application number: **23915022.0**

(22) Date of filing: **28.12.2023**

(51) International Patent Classification (IPC):
**G01R 31/396** $^{(2019.01)}$   **G01R 31/367** $^{(2019.01)}$
**G01R 31/385** $^{(2019.01)}$   **G01R 29/02** $^{(2006.01)}$
**G01R 19/12** $^{(2006.01)}$

(52) Cooperative Patent Classification (CPC):
**G01R 19/12; G01R 29/02; G01R 31/367;
G01R 31/385; G01R 31/396;** Y02E 60/10

(86) International application number:
**PCT/KR2023/021911**

(87) International publication number:
**WO 2024/147562 (11.07.2024 Gazette 2024/28)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.01.2023 KR 20230000452**

(71) Applicant: **LG Energy Solution, Ltd.
Seoul 07335 (KR)**

(72) Inventors:
• **LEE, Jeong Hwan
Daejeon 34122 (KR)**
• **PARK, Jae Dong
Daejeon 34122 (KR)**

(74) Representative: **Plasseraud IP
104 Rue de Richelieu
CS92104
75080 Paris Cedex 02 (FR)**

(54) **APPARATUS FOR DETERMINING PARAMETER OF EQUIVALENT CIRCUIT MODEL OF BATTERY, AND OPERATING METHOD THEREFOR**

(57) The parameter determination apparatus according to an embodiment disclosed in this document includes an acquisition unit configured to acquire data about a voltage of a battery during at least a time period in an idle state of the battery and a determination unit configured to detect changes in the voltage based on the data and determine a plurality of parameters representing a plurality of resistor-capacitor (RC) time constants included in an equivalent circuit model (ECM) of the battery based on the voltage changes.

FIG.1

EP 4 632 412 A1

**Description**

**[TECHNICAL FIELD]**

CROSS-REFERENCE TO RELATED APPLICATION

This application claims priority to and the benefit of Korean Patent Application No. 10-2023-0000452 filed in the Korean Intellectual Property Office on January 2, 2023, the entire contents of which are incorporated herein by reference.

TECHNICAL FIELD

The embodiments disclosed in this document relate to an apparatus for determining parameters of equivalent circuit model for a battery and operating method thereof.

**[BACKGROUND ART]**

Recently, research and development on secondary batteries have been actively conducted. Here, the secondary battery is a rechargeable battery and includes all of the conventional Ni/Cd batteries, Ni/MH batteries, and recent lithium ion batteries. Among secondary batteries, lithium-ion batteries have the advantage of much higher energy density compared to traditional Ni/Cd and Ni/MH batteries. Moreover, with their compact and lightweight design, lithium-ion batteries serve as power sources for portable devices, and their recent extension to powering electric vehicles has attracted considerable attention as a next-generation energy storage solution.

As one of the services related to these secondary batteries, there is the battery management system (BMS). The battery management system can collect data on the voltage, current, and temperature of the battery. Based on the collected measurement data, the battery management system can diagnose internal short circuits, overvoltage, temperature sensor malfunctions, and other faults.

To diagnose the state of the battery, an equivalent circuit model (ECM) of the battery can be employed. Here, the equivalent circuit model is a model that electrically simulates the variations in voltage and current output from the battery.

The battery management system has the advantage of more quickly diagnosing the state of the battery by utilizing a simplified equivalent circuit model that represents the structure of the battery.

**[DISCLOSURE]**

**[TECHNICAL PROBLEM]**

To accurately assess the state of the battery, it is necessary to accurately derive the parameters of the equivalent circuit model.

However, during the process of applying a pulse current to the battery, a delay may occur between the time the pulse current is applied and the time the voltage measured, attributed to the pulse current. In addition, errors may arise from measurement equipment that senses the battery to diagnose the state of the battery. These mentioned delays and errors pose challenges in accurately deriving the parameters of the equivalent circuit model of the battery.

In addition, conventional methods derive a plurality of RC time constant values as a whole, even though the extent to which the voltage changes depends on the RC time constant value, leading to potential inaccuracies in individual parameter values.

The technical objects of the embodiments disclosed in this document are not limited to the aforesaid, and other objects not described herein with be clearly understood by those skilled in the art from the descriptions below.

**[TECHNICAL SOLUTION]**

A parameter determination apparatus according to an embodiment disclosed in this document may include an acquisition unit configured to acquire data about a voltage of a battery during at least a time period in an idle state of the battery, and a determination unit configured to detect changes in the voltage based on the data and determine a plurality of parameters representing a plurality of resistor-capacitor (RC) time constants included in an equivalent circuit model (ECM) of the battery based on the voltage changes.

In an embodiment, the determination unit may determine the plurality of parameters based on the order of the magnitudes of the plurality of RC time constants.

In an embodiment, the determination unit may determine first parameters representing a predetermined RC time constant among the plurality of RC time constants based on data acquired during a first time interval within at least the time period.

In an embodiment, the determination unit may determine remaining parameters representing RC time constants other than the predetermined RC time constant among the plurality of RC time constants based on data acquired during a second time interval including at least part of the first time interval during at least the time period.

In an embodiment, the determination unit may determine first parameters representing a predetermined RC time constant using a first objective function representing third parameters, excluding second parameters representing a predetermined number of RC time constants, as predetermined constants among the plurality of parameters.

In an embodiment, the determination unit may determine remaining parameters, excluding the first parameters, using a second objective function representing the second and third parameters as decay constants of an exponential function.

An operating method of a parameter determination apparatus according to an embodiment disclosed in this document may include acquiring data about the voltage of a battery during at least a time period in an idle state of the battery, detecting changes in the voltage based on the data, and determining a plurality of parameters representing a plurality of resistor-capacitor (RC) constants included in an equivalent circuit model (ECM) of the battery based on the voltage changes.

In an embodiment, the determining may include determining the plurality of parameters based on the order of the magnitudes of the plurality of RC time constants.

In an embodiment, the determining may include determining first parameters representing a predetermined RC time constant among the plurality of RC time constants based on data acquired during a first time interval within at least the time period.

In an embodiment, the determining may include determing remaining parameters representing RC time constants other than the predetermined RC time constant among the plurality of RC time constants based on data acquired during a second time interval including at least part of the first time interval during at least the time period.

In an embodiment, the determining may include determining first parameters representing a predetermined RC time constant among the plurality of RC time constants using a first objective function representing third parameters, excluding second parameters representing a predetermined number of RC time constants, as predetermined constants among the plurality of parameters.

In an embodiment, the determining may include determining remaining parameters, excluding the first parameters, using a second objective function representing the second and third parameters as decay constants of an exponential function.

## [ADVANTAGEOUS EFFECTS]

The apparatus for determining the parameters of the equivalent circuit model for a battery and operating method thereof, according to various embodiments disclosed in this document, are capable of determining the parameters of the equivalent circuit model of the battery using an objective function that reflects delay values and error values.

The apparatus for determining parameters of equivalent circuit model for a battery and operating method thereof, according to various embodiments disclosed in this document, are capable of reducing errors by deriving parameters representing prioritized RC time constants among the plurality of RC time constants, instead of fitting a plurality of RC time constant values as a whole.

Accordingly, the apparatus for determining parameters of equivalent circuit model for a battery and operating method thereof is capable of accurately deriving one or more parameters included in the equivalent circuit model for the battery.

The advantageous effects of the apparatus for determining the parameters of the equivalent circuit model for a battery and operating method thereof, disclosed in this document, are not limited to the aforesaid, and other effects not described herein with can be clearly understood by those skilled in the art from the descriptions below.

## [DESCRIPTION OF DRAWINGS]

FIG. 1 is a block diagram of a parameter determination apparatus according to an embodiment of the present disclosure;

FIG. 2 illustrates an equivalent circuit model of a battery according to an embodiment of the present disclosure;

FIG. 3 illustrates a first graph depicting voltage values curve-fitted during a first time interval according to an embodiment of the present disclosure;

FIG. 4 illustrates a second graph depicting voltage values curve-fitted during a predetermined time interval according to an embodiment of the present disclosure; and

FIG. 5 is a flowchart illustrating an operating method of the parameter determination apparatus according to an embodiment of the present disclosure.

With regard to the explanation of the drawings, the same or similar reference numerals may be used for identical or similar components.

**[MODE FOR INVENTION]**

Hereinafter, embodiments of the present invention are described with reference to accompanying drawings. However, the description is not intended to limit the present invention to particular embodiments, and it should be construed as including various modifications, equivalents, and/or alternatives of the embodiments described herein.

The embodiments and terms used in this document are not intended to limit the technical features disclosed in this document to specific embodiments, and should be understood to encompass various modifications, equivalents, or alternatives to the disclosed embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (such as importance or order), unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired or wirelessly) or indirectly (e.g., through a third component).

The methods according to various embodiments disclosed in this document can be included and provided in a computer program product. The computer program product may be traded between sellers and buyers as commodities. A computer program product can be distributed in the form of a device-readable storage medium (e.g., compact disc read-only memory, CD-ROM), or it can be distributed directly, online, between two user devices, or through an application store (e.g., download or upload). In the case of online distribution, at least part of the computer program product may be temporarily stored or temporarily created in a device-readable storage medium such as a manufacturer's server, an application store server, or a relay server's memory.

According to the embodiments disclosed in this document, each of the described components (e.g., modules or programs) may include one or more entities, and some of the plurality of entities may be separately arranged in other components. According to the embodiments disclosed in this document, one or more components or operations may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to the embodiments disclosed in this document, operations performed by modules, programs, or other components are executed sequentially, in parallel, iteratively, or heuristically, or one or more of the operations are executed in a different order, omitted, or one or more other operations may be added.

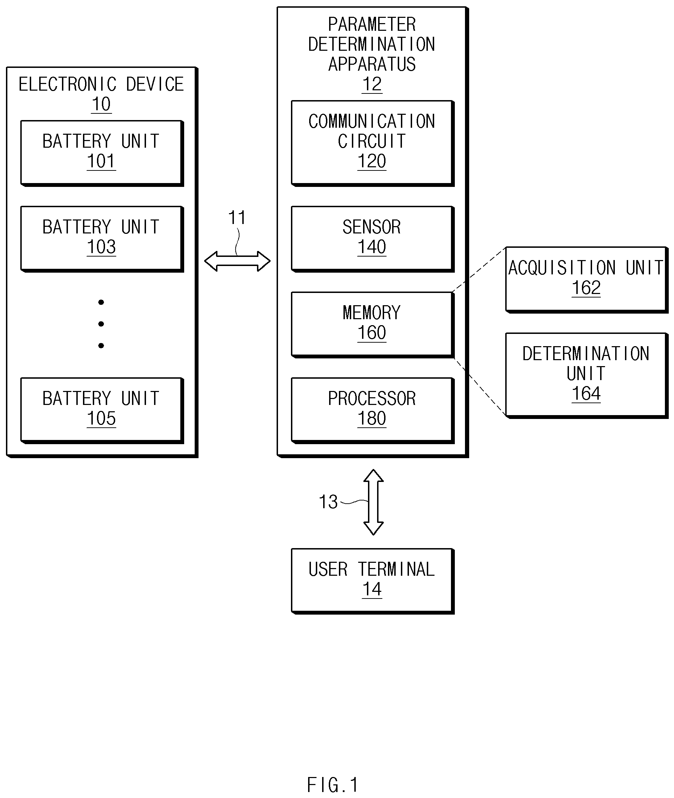

FIG. 1 is a block diagram of a parameter determination apparatus according to an embodiment of the present disclosure.

With reference to FIG. 1, the parameter determination apparatus 12 may be connected to an electronic device 10 and a user terminal 14 through a wired and/or wireless connection.

According to an embodiment, the connection 11 between the parameter determination apparatus 12 and the electronic device 10 may be a communication link established through wired and/or wireless networks. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network encompassing 4th Generation (4G) and 5G network networks).

According to another embodiment, the connection 11 between the parameter determination apparatus 12 and the electronic device 10 may be a connection established through an inter-device communication interface (e.g., bus, general purpose input and output (GPIO), serial peripheral interface (SPI), or mobile industry processor interface (MIPI)).

According to an embodiment, the connection 13 between the parameter determination apparatus 12 and the user terminal 14 may be a communication link established through wired and/or wireless networks.

In an embodiment, the electronic device 10 may be a mobile device (e.g., portable phone, laptop computer, smartphone, and smart pad), an electrified vehicle (e.g., electric vehicle (EV), hybrid EV (HEV), plug-in HEV (PHEV), and fuel cell EV (FCEV), an energy storage system (ESS), or a battery swapping system (BSS).

In an embodiment, the electronic device 10 may include one or more battery units 101, 103, and 105. Each of the one or more battery units 101, 103, and 105 may be a battery cell, battery module, battery pack, or battery rack.

In an embodiment, the user terminal 14 may be a mobile device (e.g., portable phone, laptop computer, smartphone, and smart pad) or a personal computer (PC).

In an embodiment, the parameter determining apparatus 12 may include a communication circuit 120, a sensor 140, a memory 160, and a processor 180. According to an embodiment, the parameter determination apparatus 12 shown in FIG. 1 may further include at least one additional component (e.g., a display, input device, or output device) other than the components illustrated in FIG. 1.

In an embodiment, the communication circuit 120 may establish a wired and/or wireless communication channel between the parameter determination apparatus 12 and the electronic device 10 and/or user terminal 14 and exchange data with the electronic device 10 and/or the user terminal 14 through the established communication channel.

In an embodiment, the sensor 140 may acquire values related to the state of the battery units 101, 103, and 105 of the electronic device 10. In an embodiment, the values related to the state may include one or more values representing the voltage, current, resistance, state of charge (SOC), state of health (SOH), or temperature of the battery units, or any combination thereof. In the following, a value related to a state may be referred to as a state value.

In an embodiment, the memory 160 may include volatile memory and/or nonvolatile memory.

In an embodiment, the memory 160 may store data used by at least one component of the parameter determination apparatus 12 (e.g., processor 180). For example, the data may include software (or related instructions), input data, or output data. In an embodiment, the instructions may be executed by the processor 180 for the parameter determination apparatus 12 to perform operations defined by the instructions.

In an embodiment, the memory 160 may include one or more software components (e.g., acquisition unit 162 and determination unit 164).

In an embodiment, the processor 180 may include a central processing unit, an application processor, a graphic processing unit, a neural processing unit (NPU), an image signal processor, a sensor hub processor, or a communication processor.

In an embodiment, the processor 180 may execute software (e.g., acquisition unit 162 and determination unit 164) to control at least one other component (e.g., hardware or software component) connected to the parameter determination apparatus 12 and perform various data processing or operations.

Hereinafter, a description is made of the method for the parameter determination apparatus 12 to determine a plurality of parameters included in an equivalent circuit model of a battery through the acquisition unit 162 and determination unit 164.

The acquisition unit 162 may acquire data about the battery. The acquisition unit 162 may acquire data about the voltage of the battery. The acquisition unit 162 may acquire data about the voltage of the battery while the battery is in an idle state. The acquisition unit 162 may acquire data about the voltage of the battery during at least a predetermined time interval in an idle state.

The determination unit 164 may determine parameters. The determination unit 164 may determine a plurality of parameters included in the equivalent circuit model of the battery. The determination unit 164 may determine a plurality of parameters representing a plurality of resistor-capacitor (RC) time constants included in the equivalent circuit model of the battery. The determination unit 164 may detect changes in voltage based on the data and determine a plurality of parameters representing a plurality of RC time constants included in the equivalent circuit model based on the changes in voltage. Here, the plurality of parameters may include resistance, capacitance, RC time constant, delay, error, or any combination thereof.

The determination unit 164 may determine one or more parameters based on predetermined conditions. The determination unit 164 may determine a plurality of parameters based on the order of magnitudes of a plurality of RC time constants. For example, assuming the register-capacitor pairs (RC pairs) connected in parallel, $R_1$-$C_1$, $R_2$-$C_2$, and $R_3$-$C_3$, and $R_3C_3$ having the largest time constant value, the determination unit 164 may prioritize determining parameters $R_3$ and $C_3$, representing the largest RC time constant value. Here, $R_1$, $R_2$, and $R_3$ may be the resistances of the first, second, and third resistors, respectively. $C_1$, $C_2$, and $C_3$ may be the capacitances of the first, second, and third capacitors, respectively.

Hereinafter, the description is made under the assumption that the plurality of RC pairs are $R_1$-$C_1$, $R_2$-$C_2$, and $R_3$-$C_3$, and the time constants are in the order, in magnitude, of $R_3C_3$, $R_2C_2$, and $R_1C_1$.

The determination unit 164 may determine parameters representing a specific RC time constants.

The determination unit 164 may determine first parameters representing predetermined RC time constants among the plurality of RC time constants. The determination unit 164 may determine a plurality of parameters based on data about voltage. The determination unit 164 may determine a plurality of parameters based on data acquired during the first time interval of at least a time period. The determination unit 164 may determine the first parameters representing a predetermined RC time constant among a plurality of RC time constants based on data acquired during the first time interval within at least a period. For example, the predetermined RC time constant may be the $R_3C_3$ with the largest time constant value among the RC time constants. The first parameters may include $R_3$ and $C_3$, representing $R_3C_3$. The first time interval may be at least a time interval that excludes time intervals in which the delay value and/or error value exceeds a predetermined value within a time period.

The reason the determination unit 164 prioritizes determining parameters representing a predetermined time constant among a plurality of time constants is because the impact on the voltage changes over time varies depending on the time constant values.

The determination unit 164 may determine the remaining parameters representing RC time constants other than the predetermined RC time constant among the plurality of RC time constants. The determination unit 164 may determine the remaining parameters representing RC time constants other than the predetermined RC time constant among the plurality of RC time constants based on data acquired during a second time interval including at least part of the first time interval during the at least part of the time. Here, the remaining parameters may include resistance, capacitance, delay, error, or any combinations thereof, excluding $R_3$ and $C_3$.

The determination unit 164 may determine a plurality of parameters using an objective function.

The determination unit 164 may determine a plurality of parameters using an objective function representing specific parameters as predetermined constants. The determination unit 164 may determine the first parameters using an objective function representing specific parameters as predetermined constants. The determination unit 164 may determine the first parameters using a first objective function representing third parameters as predetermined constants excluding second parameters representing a predetermined number of RC time constants among the plurality of parameters. For example, the predetermined number may be 2, and the predetermined number of RC time constants may be $R_2C_2$ and $R_3C_3$. The first parameters may include one or more of the plurality of parameters. The second parameters may include one or more of the first parameters. The first objective function may be expressed as Equation 1.

[0068] [Equation 1]

$$V[\delta] + I \cdot R_2 \cdot (1 - e^{-(\frac{t}{R_2 \cdot C_2})}) + I \cdot R_3 \cdot (1 - e^{-(\frac{\delta}{R_3 \cdot C_3})}) \cdot (1 - e^{-(\frac{t}{R_3 \cdot C_3})}) + K_1$$

Here, $V[\delta]$ may be the voltage value just before idle, and I may be the current value. $\delta$ may be the discharge time. $\delta$ may be the time elapsed since the battery was discharged until just before idle. For example, when the discharge time is 90 seconds, $\delta$ may be 90. The reason for including $\delta$ in Equation 1 may be to compensate for the varying degrees of saturation depending on the RC time constant values. For example, the RC time constant with the largest time constant value, $R_3C_3$, may have a significant impact on the voltage value depending on the discharge time just before idle compared to $R_2C_2$ and $R_1C_1$. Therefore, $\delta$ may be used to reduce the impact.

Here, $R_2$ and $R_3$ may be the resistances of the second and third resistors, respectively. $C_2$ and $C_3$ may be the second and third capacitances, respectively, and may be connected in parallel with the second and third resistances, respectively. $K_1$ may be a predetermined constant representing a correction value to correct errors generated by the measurement device. $K_1$ may include the serial resistance value $R_S$ and the first resistance value $R_1$.

With reference to Equation 1, the first parameters may include $R_3$ and $C_3$. The second parameters may include $R_2$, $R_3$, $C_2$, $C_3$, and $K_1$. The third parameters may include R1, C1, $R_S$, the delay value caused by the sensing device, the error value, or any combination thereof. The determination unit 164 may determine the first parameters using Equation 1.

The determination unit 164 may determine a plurality of parameters using a second objective function. The determination unit 164 may determine the remaining parameters, excluding the first parameters, among the plurality of parameters using the second objective function. The determination unit 164 may determine the remaining parameters, excluding the first parameters, using the second objective function representing the second and third parameters as the decay constants of an exponential function. The second objective function may be expressed as Equation 2.

[0073] [Equation 2]

$$V[\delta] + I \cdot R_S + I \cdot R_1 \cdot (1 - e^{-(\frac{t+delay}{R_1 \cdot C_1})}) + I \cdot R_2 \cdot (1 - e^{-(\frac{t+delay}{R_2 \cdot C_2})}) + I \cdot R_3 \cdot (1 - e^{-(\frac{\delta}{R_3 \cdot C_3})}) \cdot (1 - e^{-(\frac{t}{R_3 \cdot C_3})}) + K_2$$

Here, $V[\delta]$ may be the voltage value just before idle, and I may be the current value. $\delta$ may be the discharge time. $\delta$ may be the time elapsed since the battery was discharged until just before idle. The reason for including $\delta$ in Equation 2 may be to compensate for the varying degrees of saturation depending on the RC time constant values.

$R_1$, $R_2$, and $R_3$ may be the resistances of the first, second, and third resistors, respectively. $R_3$ may be a

parameter value determined in Equation 1. C1, C2 and C3 may be the first, second, and third capacitances, respectively, and may be connected in parallel with the first, second, and third resistances, respectively. $C_3$ may be a parameter value determined in Equation 1. $R_S$ may be the resistance of a series resistor. The series resistor may be connected in series with the $R_C$ pairs ($R_1$-$C_1$, $R_2$-$C_2$, and $R_3$-$C_3$) where resistors and capacitors are connected in parallel to each other. "delay" may represent a delay value. "delay" may be the delay value caused by the measurement device sensing the voltage of the battery. $K_2$ may be a correction value. $K_2$ may be a collection value to compensate for errors generated by the measurement device.

With reference to Equation 2, the second parameters may include $R_2$, $R_3$, $C_2$, $C_3$, and $K_1$. The third parameters may include $R_S$, $R_1$, $C_1$, the delay value caused by the sensing device, the error value, or any combination thereof. The determination unit 164 may determine the remaining parameters, excluding the first parameters, using Equation 2.

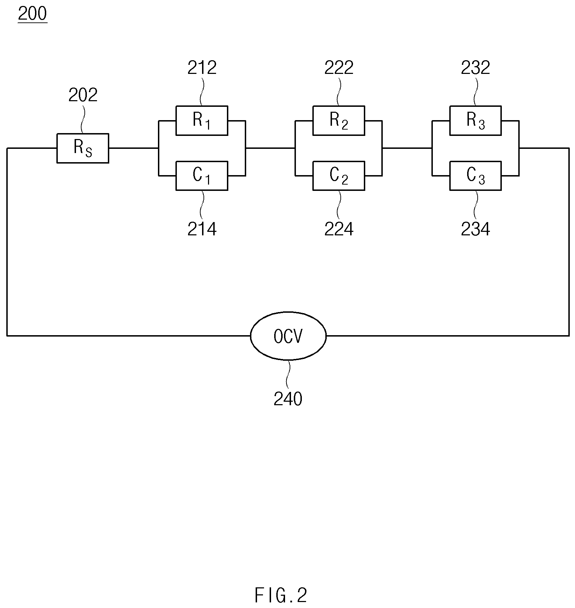

FIG. 2 illustrates an equivalent circuit model 200 of a battery according to an embodiment of the present disclosure.

With reference to FIG. 2, the equivalent circuit model 200 may include a series resistor 202, first to third resistors 212, 222, and 232, first to third capacitors 214, 224, and 234, and open-circuit voltage (OCV) 240.

The open-circuit voltage (OCV) 240 represents the discharge voltage just before the battery enters an idle state.

The acquisition unit 162 may acquire data about the voltage of the battery.

The determination unit 164 may detect changes in voltage based on data about voltage. The determination unit 164 may determine a plurality of parameters representing a plurality of RC time constants included in the equivalent circuit model 200 for the battery based on changes in voltage. The determination unit 164 may determine the parameters $R_3$ and $C_3$, which represent $R_3C_3$, the RC time constant with the highest value. The determination unit 164 may determine the remaining parameters, including $R_S$, $R_1$, $R_2$, $C_1$, $C_2$, the delay value caused by the sensing device, and the error value, using the second objective function.

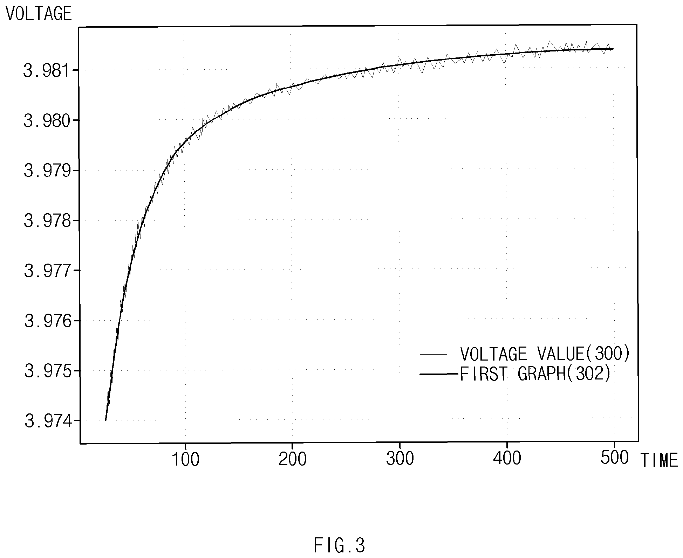

FIG. 3 illustrates a first graph 302 depicting voltage values curve-fitted during a first time interval according to an embodiment of the present disclosure.

With reference to FIG. 3, the first graph 302 may include voltage values 300 during the first time interval within a time period. Here, the time period may be from 0 seconds to 500 seconds. The first time interval may be from 25 seconds to 500 seconds.

The acquisition unit 162 may obtain voltage values 300 during the first time interval within a time period.

The determination unit 164 may detect changes in voltage values 300 and determine a plurality of parameters based on the detected changes. The determination unit 164 may detect changes in voltage values 300 and determine the first parameters using an objective function.

The determination unit 164 may perform curve fitting of the voltage values 300 based on the determined parameters. The determination unit 164 can generate a first graph 302 by curve-fitting the voltage values 300 based on the determined parameters.

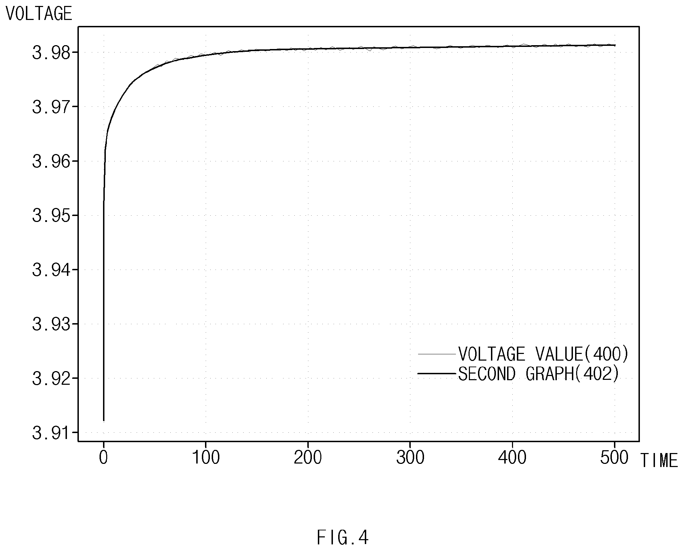

FIG. 4 illustrates a second graph 402 depicting voltage values curve-fitted during a predetermined time interval according to an embodiment of the present disclosure.

With reference to FIG. 4, the second graph 402 may include voltage values 400 during a time period. Here, the time period may be from 0 seconds to 500 seconds.

The acquisition unit 162 may obtain voltage values 400 during a time period.

The determination unit 164 may detect changes in voltage values 400 and determine a plurality of parameters based on the detected changes. The determination unit 164 may detect changes in the voltage values 400 and determine the remaining parameters, excluding the first parameters, among the plurality of parameters using the second objective function.

The determination unit 164 may perform curve fitting of the voltage values 400 based on the determined parameters. The determination unit 164 can generate a second graph 402 by curve-fitting the voltage values 400 based on the determined parameters.

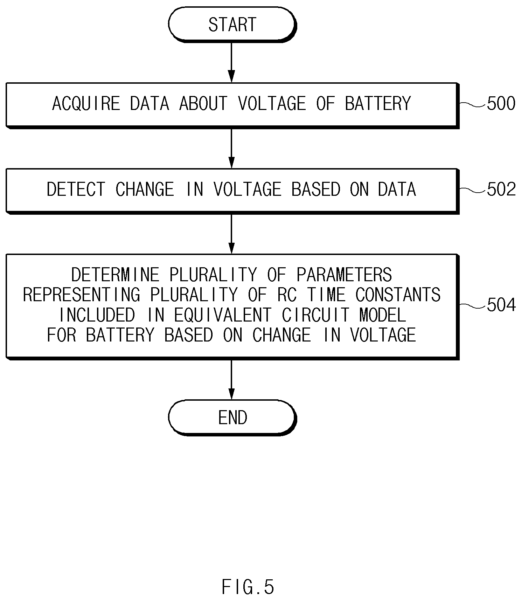

FIG. 5 is a flowchart illustrating an operating method of the parameter determination apparatus 12 according to an embodiment of the present disclosure.

With reference to FIG. 5, the acquisition unit 162 may obtain data about the battery in operation 500. The acquisition unit 162 may acquire data about the voltage of the battery. The acquisition unit 162 may acquire data about the voltage of the battery while the battery is in an idle state. The acquisition unit 162 may acquire data about the voltage of the battery during at least a predetermined time interval in an idle state.

In operation 502, the determination unit 164 may detect changes in the voltage of the battery. The determination unit 164 may detect changes in the voltage based on data about the voltage of the battery.

In operation 504, the determination unit 164 may determine parameters. The determination unit 164 may determine a plurality of parameters included in the equivalent circuit model of the battery. The determination unit 164 may determine a plurality of parameters representing a plurality of resistor-capacitor (RC) time constants included in the equivalent circuit model of the battery. The determination unit 164 may detect changes in voltage based on the data and determine a plurality of parameters representing a plurality of RC time constants included in the equivalent circuit model based on the changes in voltage.

The determination unit 164 may determine one or more parameters based on predetermined conditions. The determination unit 164 may determine a plurality of parameters based on the order of magnitudes of a plurality of RC time constants.

The determination unit 164 may determine parameters representing a specific RC time constants.

The determination unit 164 may determine first parameters representing predetermined RC time constants among the plurality of RC time constants. The determination unit 164 may determine a plurality of parameters based on data about voltage. The determination unit 164 may determine a plurality of parameters based on data acquired during the first time interval of at least a time period. The determination unit 164 may determine the first parameters representing a predetermined RC time constant among a plurality of RC time constants based on data acquired during the first time interval within at least a period.

The determination unit 164 may determine the remaining parameters representing RC time constants other than the predetermined RC time constant among the plurality of RC time constants. The determination unit 164 may determine the remaining parameters representing RC time constants other than the predetermined RC time constant among the plurality of RC time constants based on data acquired during a second time interval including at least part of the first time interval during the at least part of the time.

The determination unit 164 may determine a plurality of parameters using an objective function.

The determination unit 164 may determine a plurality of parameters using an objective function representing specific parameters as predetermined constants. The determination unit 164 may determine the first parameters using an objective function representing specific parameters as predetermined constants. The determination unit 164 may determine the first parameters using a first objective function representing third parameters as predetermined constants excluding second parameters representing a predetermined number of RC time constants among the plurality of parameters.

The determination unit 164 may determine a plurality of parameters using a second objective function. The determination unit 164 may determine the remaining parameters, excluding the first parameters, among the plurality of parameters using the second objective function. The determination unit 164 may determine the remaining parameters, excluding the first parameters, among a plurality of parameters using the second objective function representing the second and third parameters as the decay constants of an exponential function.

Also, the terms such as "comprise", "include", or "have" used above implies that the corresponding component may be present unless otherwise stated specifically, and thus it should be construed as being able to further include other components rather than exclude other components. Unless otherwise defined, all terms, including technical or scientific terms used herein, have the same meanings as commonly understood by those skilled in the art to which the embodiments disclosed in this invention belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

The above description is only an illustrative example of the technical idea disclosed in this document, and those skilled in the art to which the embodiments disclosed in this document belong will be able to make various modification and changes without departing from the subject matter of the embodiments disclosed in this document. Therefore, the embodiments disclosed in this document are not intended to limit the technical concept disclosed in this document but are for the purpose of illustration, and the scope of the technical concept disclosed in this document is not limited by these embodiments. The scope of protection for the technical concepts disclosed in this document should be interpreted in accordance with the claims set forth below, and all equivalent technical concepts should be considered as included in the scope of protection of this document.

## Claims

1. A parameter determination apparatus comprising:

    an acquisition unit configured to acquire data about a voltage of a battery during at least a time period in an idle state of the battery; and
    a determination unit configured to detect changes in the voltage based on the data and determine a plurality of parameters representing a plurality of resistor-capacitor (RC) time constants included in an equivalent circuit model (ECM) of the battery based on the voltage changes.

2. The parameter determination apparatus of claim 1, wherein the determination unit determines the plurality of parameters based on the order of the magnitudes of the plurality of RC time constants.

3. The parameter determination apparatus of claim 1, wherein the determination unit determines first parameters representing a predetermined RC time constant among the plurality of RC time constants based on data acquired during a first time interval within at least the time period.

4. The parameter determination apparatus of claim 3, wherein the determination unit determines remaining parameters representing RC time constants other than the predetermined RC time constant among the plurality of RC time constants based on data acquired during a second time interval including at least part of the first time interval during at least the time period.

5. The parameter determination apparatus of claim 1, wherein the determination unit determines first parameters representing a predetermined RC time constant using a first objective function representing third parameters, excluding second parameters representing a predetermined number of RC time constants, as predetermined constants among the plurality of parameters.

6. The parameter determination apparatus of claim 5, wherein the determination unit determines remaining parameters, excluding the first parameters, using a second objective function representing the second and third parameters as decay constants of an exponential function.

7. An operating method of a parameter determination apparatus, the method comprising:

   acquiring data about the voltage of a battery during at least a time period in an idle state of the battery; detecting changes in the voltage based on the data; and
   determining a plurality of parameters representing a plurality of resistor-capacitor (RC) constants included in an equivalent circuit model (ECM) of the battery based on the voltage changes.

8. The method of claim 7, wherein the determining comprises determining the plurality of parameters based on the order of the magnitudes of the plurality of RC time constants.

9. The method of claim 7, wherein the determining comprises determining first parameters representing a predetermined RC time constant among the plurality of RC time constants based on data acquired during a first time interval within at least the time period.

10. The method of claim 9, wherein the determining comprises determining remaining parameters representing RC time constants other than the predetermined RC time constant among the plurality of RC time constants based on data acquired during a second time interval including at least part of the first time interval during at least the time period.

11. The method of claim 7, wherein the determining comprises determining first parameters representing a predetermined RC time constant among the plurality of RC time constants using a first objective function representing third parameters, excluding second parameters representing a predetermined number of RC time constants, as predetermined constants among the plurality of parameters.

12. The method of claim 11, wherein the determining comprises determining remaining parameters, excluding the first parameters, using a second objective function representing the second and third parameters as decay constants of an exponential function.

FIG.1

200

FIG.2

FIG.3

FIG.4

START

ACQUIRE DATA ABOUT VOLTAGE OF BATTERY ~500

DETECT CHANGE IN VOLTAGE BASED ON DATA ~502

DETERMINE PLURALITY OF PARAMETERS
REPRESENTING PLURALITY OF RC TIME CONSTANTS
INCLUDED IN EQUIVALENT CIRCUIT MODEL ~504
FOR BATTERY BASED ON CHANGE IN VOLTAGE

END

FIG.5

## INTERNATIONAL SEARCH REPORT

| International application No. |
| --- |
| **PCT/KR2023/021911** |

| A. | CLASSIFICATION OF SUBJECT MATTER |
| --- | --- |

**G01R 31/396**(2019.01)i; **G01R 31/367**(2019.01)i; **G01R 31/385**(2019.01)i; **G01R 29/02**(2006.01)i; **G01R 19/12**(2006.01)i

According to International Patent Classification (IPC) or to both national classification and IPC

| B. | FIELDS SEARCHED |
| --- | --- |

Minimum documentation searched (classification system followed by classification symbols)

G01R 31/396(2019.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 등가 회로 모델(equivalent circuit model), 전압 변화(voltage change), 파라미터(parameter), 시정수(time constant)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2021-001864 A (GS YUASA CORP.) 07 January 2021 (2021-01-07)<br>See paragraph [0051], claims 1-3 and figures 3-4. | 1-4,7-10 |
| A | | 5-6,11-12 |
| A | JP 2015-224919 A (DENSO CORP.) 14 December 2015 (2015-12-14)<br>See claims 1-2 and figures 1-6. | 1-12 |
| A | KR 10-2019-0050169 A (LG CHEM, LTD.) 10 May 2019 (2019-05-10)<br>See claims 1-3 and figures 1-4. | 1-12 |
| A | JP 2017-138128 A (DENSO CORP.) 10 August 2017 (2017-08-10)<br>See claims 1-2 and figures 1-3. | 1-12 |
| A | KR 10-2021-0118668 A (LG ENERGY SOLUTION, LTD.) 01 October 2021 (2021-10-01)<br>See claim 1 and figures 1-5. | 1-12 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **03 April 2024** | **03 April 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/021911**

| Patent document cited in search report | | | Publication date (day/month/year) | Patent family member(s) | | | Publication date (day/month/year) |
|---|---|---|---|---|---|---|---|
| JP | 2021-001864 | A | 07 January 2021 | CN | 114008470 | A | 01 February 2022 |
| | | | | JP | 7342671 | B2 | 12 September 2023 |
| | | | | US | 2022-0237342 | A1 | 28 July 2022 |
| | | | | WO | 2020-255794 | A1 | 24 December 2020 |
| JP | 2015-224919 | A | 14 December 2015 | JP | 6287582 | B2 | 07 March 2018 |
| KR | 10-2019-0050169 | A | 10 May 2019 | CN | 110573892 | A | 13 December 2019 |
| | | | | CN | 110573892 | B | 22 October 2021 |
| | | | | EP | 3627167 | A1 | 25 March 2020 |
| | | | | EP | 3627167 | B1 | 26 April 2023 |
| | | | | JP | 2020-521947 | A | 27 July 2020 |
| | | | | JP | 6848143 | B2 | 24 March 2021 |
| | | | | US | 11119157 | B2 | 14 September 2021 |
| | | | | US | 2021-0165046 | A1 | 03 June 2021 |
| | | | | WO | 2019-088492 | A1 | 09 May 2019 |
| JP | 2017-138128 | A | 10 August 2017 | JP | 6414558 | B2 | 31 October 2018 |
| | | | | US | 10890625 | B2 | 12 January 2021 |
| | | | | US | 2019-0064276 | A1 | 28 February 2019 |
| | | | | WO | 2017-135075 | A1 | 10 August 2017 |
| KR | 10-2021-0118668 | A | 01 October 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230000452